# EUROPEAN PATENT APPLICATION

(11) **EP 3 573 109 A1**
(43) Date of publication of application: **27.11.2019**
(21) Application number: 17892978.2
(22) Date of filing: 20.12.2017
(51) Int. Cl.: H01L 29/861, H01L 29/78, H01L 29/868, H02M 7/48

(54) **SEMICONDUCTOR DEVICE AND ELECTRIC POWER CONVERSION DEVICE USING SAME**

(30) Priority: 18.01.2017 JP 2017006836
(71) Applicant: Hitachi Power Semiconductor Device, Ltd., Hitachi-shi, Ibaraki 319-1221 (JP)
(72) Inventor: MIYOSHI, Tomoyuki, Tokyo 100-8280 (JP); MORI, Mutsuhiro, Tokyo 100-8280 (JP); TAKEUCHI, Yujiro, Tokyo 100-8280 (JP); FURUKAWA, Tomoyasu, Tokyo 100-8280 (JP)
(74) Representative: Strehl Schübel-Hopf & Partner
(86) International application number: PCT/JP2017/045754
(87) International publication number: WO 2018/135224

(57) **Abstract**

Provided are a semiconductor device that has both capabilities of low conduction loss and low recovery loss established, and that is capable of lowering power consumption, and an electric power conversion device using same. The invention is characterized in that: an anode region is configured including a first anode region of a second electrically conductive type, a well region of a first electrically conductive type, and a second anode region of the second electrically conductive type in sequence facing from a first surface side to a second surface side; the first anode region is separated from the second anode region and the anode electrode by the well region; the well region and the second anode region are both connected to the anode electrode, and separated from the semiconductor substrate; the first anode region, the well region, and the second anode region are all connected to the gate electrode with the gate insulation film interposed; and when a negative bias is applied to the gate electrode with respect to the anode electrode, the portion of the well region in contact with the gate insulation film has an inversion layer formed, and when a positive bias is applied to the anode electrode with respect to a cathode electrode, a positive hole is injected in a drift layer from the inversion layer formed on the well region.

## Description

### Technical Field

The present invention relates to a structure of a semiconductor device and a manufacturing method thereof, and more particularly to a technique effective when applied to power semiconductor devices for power control.

### Background Art

Global warming is an important urgent issue common to the world, and as one of countermeasures, the expectation of contribution of power electronics technology is increasing. Particularly, in order to improve the efficiency of an inverter that controls a power conversion function, it is required to reduce in power consumption of an IGBT (Insulated Gate Bipolar Transistor) which performs a power switching function constituting the power conversion function, and a power semiconductor device mainly composed of a diode which performs a rectifying function

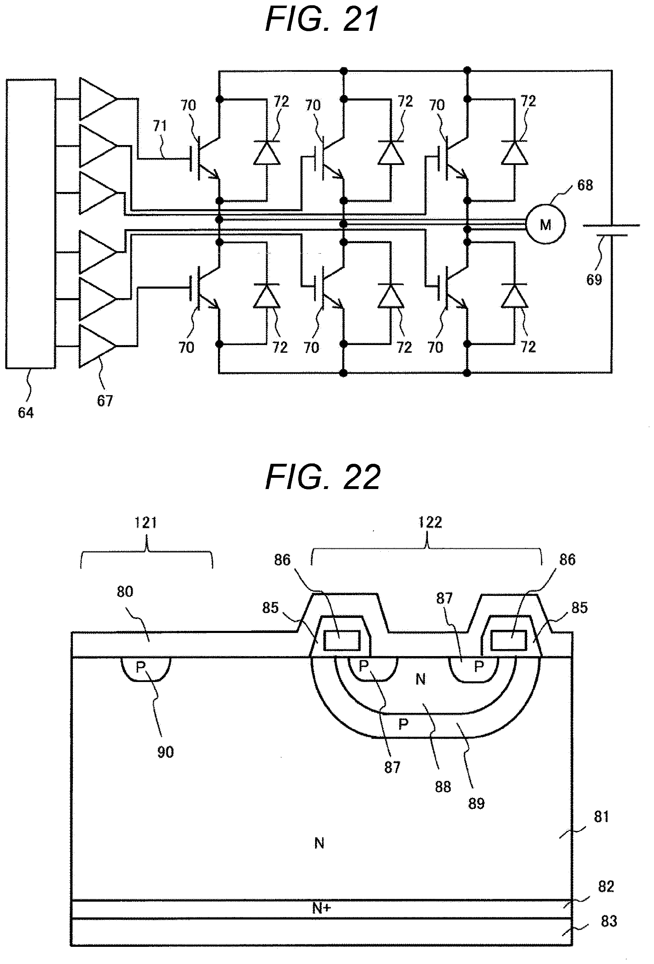

FIG. 21 illustrates a partial circuit diagram of the inverter. To an IGBT 70 having an insulated gate terminal 71, a diode 72 is connected anti-parallel to the IGBT 70. The inverter is powered from a voltage source 69 and controls the power to be supplied to an inductive load 68 connected by applying a voltage to the insulated gate 71 of the IGBT 70 and repeatedly turning on and turning off at high speed. The inductive load 68 is, for example, a motor (electric motor).

Since a conduction loss occurs in the IGBT 70 and the diode 72 at the time of conduction, and a switching loss occurs at the time of switching, it is necessary to reduce the conduction loss and the switching loss in the IGBT 70 and the diode 72 to miniaturize an inverter and achieve high efficiency. Here, the switching loss includes a turn-on loss and a turn-off loss generated from the IGBT, and a recovery loss generated from the diode at turn-on.

As a technique for reducing a conduction loss and a recovery loss of a diode, a technique relating to a diode connecting diodes having a switching function described in PTLS 1 and 2 in parallel is known. For example, the diode described in PTL 1 has a structure in which a diode that is always connected and a diode with a switch that can control conduction/non-conduction at a control gate are connected in parallel. FIG. 22 illustrates a conventional diode described in PTL 1, and the diode that is always connected and a diode with a conduction/non-conduction control function by a MOSFET switch are connected in parallel. In a cathode drift layer 81 consisting of a low concentration N type impurity, a high concentration N+ type cathode layer 82 for electrically connecting with a cathode electrode 83 is disposed.

On an upper surface of the cathode drift layer 81, a P type anode layer 89 consisting of P type impurities, an N type well layer 88 consisting of N type impurities, a P type anode layer 87, an anode electrode 80 in contact with the N type well layer 88 and the P type anode layer 87 are disposed. Further, an insulated gate consisting of a gate insulating film 85 in contact with the P type anode layers 87 and 89 and the N type well layer 88 and a gate electrode 86 is disposed. In addition, a P type anode auxiliary layer 90 is disposed in a region where the P type anode layer 89 is not formed, and the anode electrode 80 is disposed on the P type anode auxiliary layer 90.

In the region where the P type anode auxiliary layer 90 is disposed, a diode connected to the cathode electrode 83 from the anode electrode 80 via the cathode drift layer 81 is formed. On the other hand, in the region where the P type anode layer 89 is disposed, a carrier concentration can be modulated and controlled in a region in contact with the gate oxide film 85 of the N type well layer 88 by a voltage signal to the gate electrode 86. Consequently, it is possible to control conduction/non-conduction of a diode by the P type anode layer 87 and the N type cathode drift layer 81 by a gate voltage. As described above, the diode described in PTL 1 has a structure in which a diode portion 121 which is always connected and a diode portion 122 having a conduction/non-conduction control function by a MOSFET switch are connected in parallel.

When the diode is in a conduction state, an on-voltage signal is applied to a control gate, and the MOSFET switch attached diode portion 122 is made conductive, such that a concentration of hole carriers injected from an anode into a cathode drift layer can be increased, and a forward voltage can be reduced. On the other hand, immediately before a recovery state in which a diode transitions from a conduction state to a non-conduction state, carriers injected from the P type anode layer 87 into the cathode drift layer 81 are suppressed by providing an off-voltage signal to a control gate and making a diode portion with a switch nonconductive, and the recovery current caused by a reverse voltage applied to a diode can be reduced by reducing a carrier concentration in the cathode drift layer 81.

In this way, since the hole injection efficiency from an anode can be controlled by a voltage applied to the control gate, the trade-off between a forward voltage related to a conduction loss and a recovery loss can be improved.

Further, as in PTL 1, the diode described in PTL 2 has a structure in which a diode that is always connected and a diode with a switch that can control conduction/non-conduction at a control gate are connected in parallel, but it is characterized by the shape of the gate. FIG. 23 illustrates a conventional diode described in PTL 2. The gate electrode 86 and the gate oxide film 85 surrounding the gate electrode 86 have a trench embedded shape. Accordingly, the switch that can control the conduction/non-conduction of the diode has a vertical MOSFET structure. As described above, the diode described in PTL 2 has a structure in which the diode portion 121 that is always connected and the diode portion 122 that is provided with a conduction/nonconduction control function by a vertical MOSFET switch including a gate having a trench embedded shape are connected in parallel.

In contrast to the lateral MOSFET shape described in PTL 1, in the vertical MOSFET shape described in PTL 2, the injection direction of hole carriers from the P type anode layer 87 is perpendicular to the arrangement direction of the cathode electrode 88, and an on-resistance can be lowered. Accordingly, a forward voltage at the time of conduction can be further lowered as compared with the diode of PTL 1. As a result, the trade-off characteristic relationship between a forward voltage related to a conduction loss and a recovery loss has been improved.

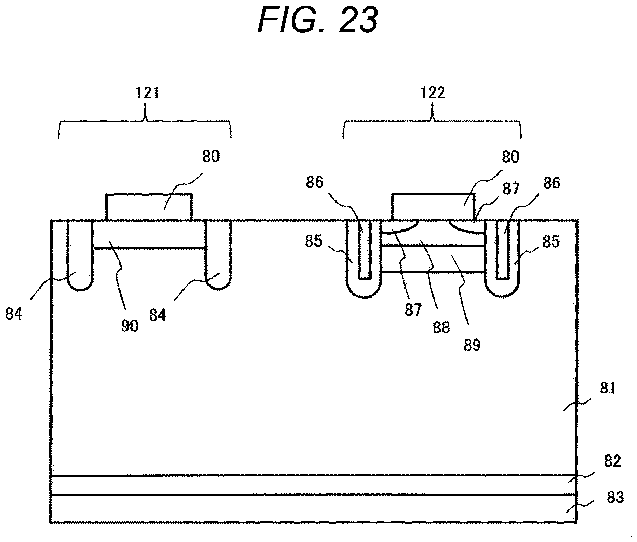

However, in the diodes in FIGS. 22 and 23, since hole carriers are injected from the P type anode auxiliary layer 90 in the diode portion 121 that is always connected irrespective of a gate voltage, hole carriers in the cathode drift layer 81 remain even if the diode portion 122 with a switch is made nonconductive immediately before a recovery state. Due to the existence of the hole carriers, the reduction of a recovery current is limited, and it is difficult to improve trade-off characteristics between a conduction loss of a diode and a recovery loss in these structures.

### Citation List

### Patent Literature

PTL 1: JP H09-107097 A
PTL 2: JP 2012-146977 A

### Summary of Invention

### Technical Problem

An object of the present invention is to further improve a trade-off relationship between the reduction of forward voltage drop and the reduction of a recovery current with respect to the diode disclosed in the prior art and to simultaneously reduce a conduction loss and a switching loss of a diode. Another object of the present invention is to provide a semiconductor device capable of reducing power consumption and a power converter to which the semiconductor device is applied.

### Solution to Problem

To solve the above-described problem, according to the present invention, in a semiconductor device and a power converter using the semiconductor device includes:
a first conductivity type semiconductor substrate;
a first conductivity type cathode region provided on a side of a first surface of the semiconductor substrate;
an anode region provided on a side of a second surface opposite to the first surface side of the semiconductor substrate;
an anode electrode adjacent to the second surface side of the anode region; and
a gate electrode adjacent to the anode region via a gate insulating film.

The gate electrode is surrounded by the gate insulating film in a trench that extends from the second surface to the cathode region through the anode region,
the anode region includes, in order from the first surface side to the second surface side, a second conductivity type first anode region, a first conductivity type well region, and a second conductivity type second anode region,
the first anode region is separated from the second anode region and the anode electrode by the well region,
both the well region and the second anode region are connected to the anode electrode and separated from the semiconductor substrate,
the first anode region, the well region, and the second anode region are all adjacent to the gate electrode via the gate insulating film,
when a negative bias is applied to the gate electrode with respect to the anode electrode, an inversion layer is formed in a portion of the well region in contact with the gate insulating film, and when a positive bias is applied to the anode electrode with respect to a cathode electrode, holes are injected from an inversion layer formed in the well region into a drift layer.

Further, according to the present invention, in the semiconductor device and the power converter using the semiconductor device,
the first anode region, the well region, and the second anode region are provided so as to be sandwiched between two gate electrodes,
a plurality of the first anode regions, the well regions, and the second anode regions are provided on the second surface side, and
a distance between two gate electrodes sandwiching the first anode region, the well region, and the second anode region is narrower than a distance between the gate electrode and another gate electrode adjacent to each gate electrode.

Furthermore, according to the present invention, in the semiconductor device and the power converter using the semiconductor device,
the gate electrode is in contact with different sidewalls of one trench, and
the gate electrode is a side gate type gate electrode having a sidewall shape in which the width increases from the second surface side to the first surface side.

Furthermore, according to the present invention, in the semiconductor device and the power converter using the semiconductor device,
a lifetime control region for performing lifetime control of carriers is provided in the cathode region.

Furthermore, according to the present invention, in the semiconductor device and the power converter using the semiconductor device,
a negative bias for forming an inversion layer to the well region is applied to the gate electrode in a conduction period during which a forward current flows to the semiconductor device,
before a period in which the semiconductor device transitions from a conduction state to a non-conduction state,
a positive bias or a zero bias for forming an inversion layer in the first anode region is applied to the gate electrode,
a voltage lower than a threshold voltage for forming an inversion layer in the first anode region is applied to the gate electrode during the period in which the semiconductor device transitions from the conduction state to the non-conduction state, and
the negative bias for forming the inversion layer in the well region is applied to the gate electrode in the non-conduction period of the semiconductor device.

Furthermore, according to the present invention, in the semiconductor device and the power converter using the semiconductor device,
a part of the gate electrode is connected to a first gate terminal, a remaining part of the gate electrode is connected to a second gate terminal, and the partial gate electrode and the remaining gate electrode can be controlled independently of each other via the first and second gate terminals.

Furthermore, according to the present invention, in the semiconductor device and the power converter using the semiconductor device,
during a conduction period in which a forward current flows in the semiconductor device, a part of the gate electrode connected to the first gate terminal and the remaining gate electrode connected to the second gate terminal are applied with a negative bias for forming an inversion layer in the well region,
before a period in which the semiconductor device transitions from a conduction state to a non-conduction state,
a part of the gate electrode connected to the first gate terminal is applied with a bias lower than a threshold voltage for forming an inversion layer in the first anode region and higher than a threshold voltage for forming an inversion layer in the well region is applied.

Furthermore, according to the present invention, in the semiconductor device and the power converter using the semiconductor device,
before the period in which the semiconductor device transitions from the conduction state to the non-conduction state, a bias lower than a threshold voltage for forming an inversion layer in the first anode region is applied to the remaining gate electrode connected to the second gate terminal.

Furthermore, according to the present invention, in the semiconductor device and the power converter using the semiconductor device,
during a non-conduction period of the semiconductor device, a part of the gate electrode connected to the first gate terminal and the remaining gate electrode connected to the second gate terminal are applied with the negative bias for forming the inversion layer in the well region.

Furthermore, according to the present invention, in the semiconductor device and the power converter using the semiconductor device,
before the period in which the semiconductor device transitions from the conduction state to the non-conduction state, a part of the gate electrode connected to the first gate terminal or a part of the gate electrode connected to the first gate terminal and the remaining gate electrode connected to the second gate terminal are applied with a positive bias or zero bias for forming an inversion layer in the first anode region.

Furthermore, according to the present invention, in the semiconductor device and the power converter using the semiconductor device,
a switching element including an insulated gate bipolar transistor capable of applying a driving signal is connected to the semiconductor device, and a power conversion function is provided.

Furthermore, according to the present invention, in the semiconductor device and the power converter using the semiconductor device,
a switching element including an insulated gate bipolar transistor having a first gate terminal and a second gate terminal and applying driving signals different from each other to the first gate terminal and the second gate terminal is connected to the semiconductor device, and the power conversion function is provided.

### Advantageous Effects of Invention

According to the present invention, at the time of conduction when a forward current flows through a diode, a current can flow with a small forward voltage drop due to a bias applied to a gate terminal, and also, immediately before a recovery state during which the diode transitions from a conduction state to a non-conduction state, a carrier concentration can be reduced by a bias applied to the gate, and a recovery current can also be reduced. Therefore, since both a conduction loss and a recovery loss of a diode can be reduced, it is possible to provide a semiconductor device capable of lowering power consumption, compared to the semiconductor device described in the prior art, and a power converter using the semiconductor device.

Issues, configurations, and effects other than the above are clarified by descriptions of the following embodiments.

### Brief Description of Drawings

[FIG. 1A] FIG. 1A is a cross-sectional view of a semiconductor device according to a first embodiment of the present invention.
[FIG. 1B] FIG. 1B is a cross-sectional view of a plurality of insulated gate portions disposed in the semiconductor device according to the first embodiment of the present invention.
[FIG. 2] FIG. 2 is a view conceptually illustrating a carrier distribution when a negative voltage is applied between a gate and an anode, and a forward voltage is applied to a diode in the semiconductor device according to the first embodiment of the present invention.
[FIG. 3] FIG. 3 is a view conceptually illustrating a carrier distribution when a positive voltage is applied between a gate and an anode, and a forward voltage is applied to a diode in the semiconductor device according to the first embodiment of the present invention.
[FIG. 4] FIG. 4 is a graph of forward characteristics of the semiconductor device according to the first embodiment of the present invention.
[FIG. 5] FIG. 5 is a diagram illustrating a circuit configuration of a circuit for evaluating recovery characteristics of the semiconductor device according to the first embodiment of the present invention.
[FIG. 6] FIG. 6 is a graph illustrating transient characteristics of current and voltage at the time of recovery indicated by the semiconductor device according to the first embodiment of the present invention, and a gate driving sequence at a transition from a conduction state applied to the transient characteristics to a reverse direction state.
[FIG. 7] FIG. 7 is a cross-sectional view of a semiconductor device according to a second embodiment of the present invention.
[FIG. 8A] FIG. 8A is a cross-sectional view of a semiconductor device according to a third embodiment of the present invention.
[FIG. 8B] FIG. 8B is a cross-sectional view of a plurality of insulated gate portions of a semiconductor device according to the third embodiment of the present invention.
[FIG. 9A] FIG. 9A is a diagram conceptually indicating the movement of hole carriers during recovery in the semiconductor device according to the first embodiment of the present invention.
[FIG. 9B] FIG. 9B is a view conceptually indicating the movement of hole carriers during recovery in the semiconductor device according to the third embodiment of the present invention.
[FIG. 10A] FIG. 10A is a cross-sectional view of a semiconductor device according to a fourth embodiment of the present invention.
[FIG. 10B] FIG. 10B is a cross-sectional view of a plurality of insulated gate portions disposed in the semiconductor device according to the fourth embodiment of the present invention.
[FIG. 11A] FIG. 11A is a cross-sectional view of a semiconductor device according to a fifth embodiment of the present invention.
[FIG. 11B] FIG. 11B is a plan layout view of the semiconductor device according to the fifth embodiment of the present invention.
[FIG. 12A] FIG. 12A is a cross-sectional view of the semiconductor device according to a first variation of the fifth embodiment of the present invention.
[FIG. 12B] FIG. 12B is a plan layout view of the semiconductor device according to the first variation of the fifth embodiment of the present invention.
[FIG. 13A] FIG. 13A is a cross-sectional view of a semiconductor device according to a second variation of the fifth embodiment of the present invention.
[FIG. 13B] FIG. 13B is a plan layout view of the semiconductor device according to the second variation of the fifth embodiment of the present invention.
[FIG. 14] FIG. 14 is a graph of a first gate driving sequence applied to a fifth embodiment and the variations of the present invention.
[FIG. 15] FIG. 15 is a graph of a second gate driving sequence applied to the fifth embodiment and the variations of the present invention.
[FIG. 16] FIG. 16 is a graph of a third gate driving sequence applied to the fifth embodiment and the variations of the present invention.
[FIG. 17] FIG. 17 is a graph of a fourth gate driving sequence applied to the fifth embodiment and the variations of the present invention.
[FIG. 18] FIG. 18 is a diagram illustrating a circuit configuration of a power converter according to a sixth embodiment of the present invention.
[FIG. 19] FIG. 19 is a diagram illustrating a circuit configuration of a power converter according to a first variation of the sixth embodiment of the present invention.
[FIG. 20] FIG. 20 is a diagram illustrating a circuit configuration of a power converter according to a second variation of the sixth embodiment of the present invention.
[FIG. 21] FIG. 21 is a diagram illustrating a circuit configuration of a power converter to which a conventional technique is applied.
[FIG. 22] FIG. 22 is a cross-sectional view of a semiconductor device to which the related art described in PTL 1 is applied.
[FIG. 23] FIG. 23 is a cross-sectional view of a semiconductor device to which the related art described in PTL 2 is applied.

### Description of Embodiments

An embodiment of the present invention will be described below with reference to the drawings. In the drawings, the reference signs "N-", "N", and "N+" indicate that a semiconductor layer is an N type and that the impurity concentration is relatively high in this order. In addition, the reference signs "P-" and "P" indicate that a semiconductor layer is a P type, and that the impurity concentration is relatively high in this order.

### First Embodiment

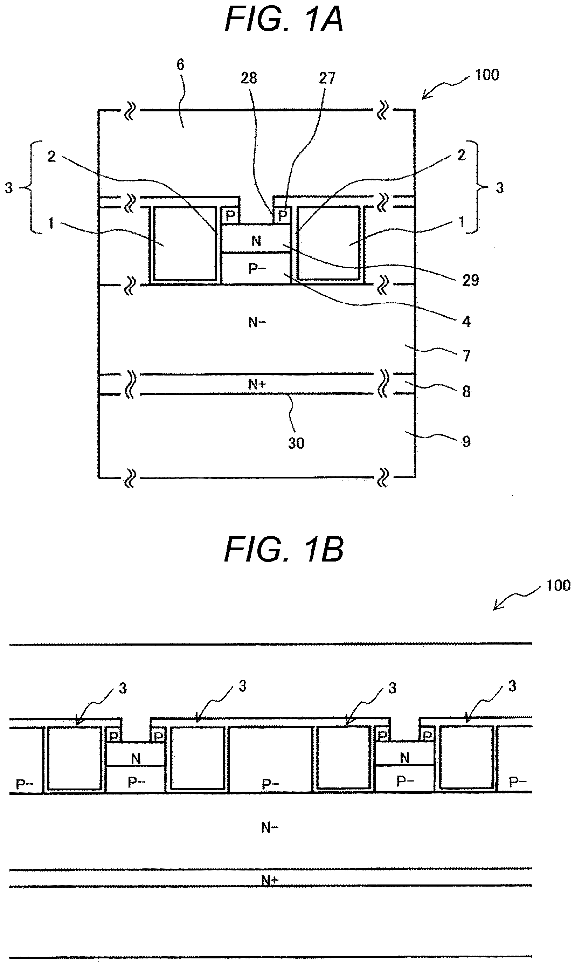

An insulated gate type (gate control type) semiconductor device 100 according to a first embodiment of the present invention will be described with reference to FIGS. 1A and 1B. FIGS. 1A and 1B are cross-sectional views of an insulated gate type vertical semiconductor device according to the present embodiment. FIG. 1A partially illustrates the vicinity of two trench gate type insulated gates 3. FIG. 1B illustrates a state in which a plurality of trench gate type insulated gates 3 (here, four insulated gates 3) are disposed.

This embodiment is a trench gate control type diode and includes an N- type cathode drift layer 7, a P- type anode layer 4 vertically adjacent to the N- type cathode drift layer 7, an N+ type cathode layer 8 vertically adjacent to the N- type cathode drift layer 7 on the side opposite to the P- type anode layer 4. Furthermore, an N type well layer 29 is adjacent on an upper portion of the P- type anode layer 4, and a P type anode layer 27 is provided thereon. The P- type anode layer 4, the N type well layer 29, and the P type anode layer 27 are in contact with the trench gate type insulated gate 3 having a gate electrode 1 via a gate insulating film (gate oxidation) 2.

That is, an anode region includes the P- type anode layer 4, the N type well layer 29, and the P type anode layer 27 in order from a lower layer to an upper layer.

An anode electrode 6 has a downwardly convex trench shape and is in contact with the P type anode layer 27 and the N type well layer 29, and the anode electrode 6 is electrically separated from the P- type anode layer 4 via the N type well layer 29. Furthermore, the anode electrode 6 is electrically connected to the P type anode layer 27 by a Schottky or an ohmic contact (barrier) 28, and the cathode electrode 9 is electrically connected to the N+ type cathode layer 8 by an ohmic contact 30. Note that the semiconductor layer used here is formed of silicon (Si) or silicon carbide (SiC), and a gate insulating film 2 is formed of silicon dioxide (SiO₂).

That is, the anode electrode 6 has a convex shape from an upper layer to a lower layer, and a position in contact with the P type anode layer 27 is formed to be higher than a position in contact with the N type well layer 29. Both the N type well layer 29 and the P type anode layer 27 are electrically connected to the anode electrode 6 and electrically separated from a semiconductor substrate.

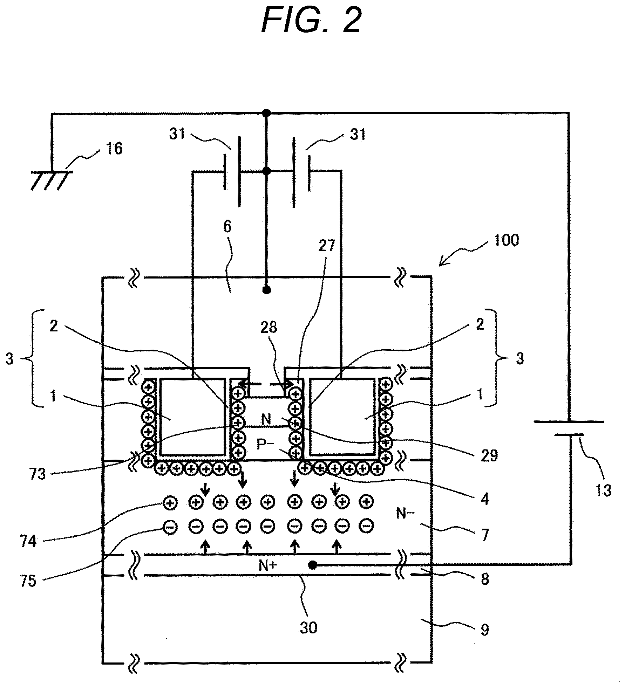

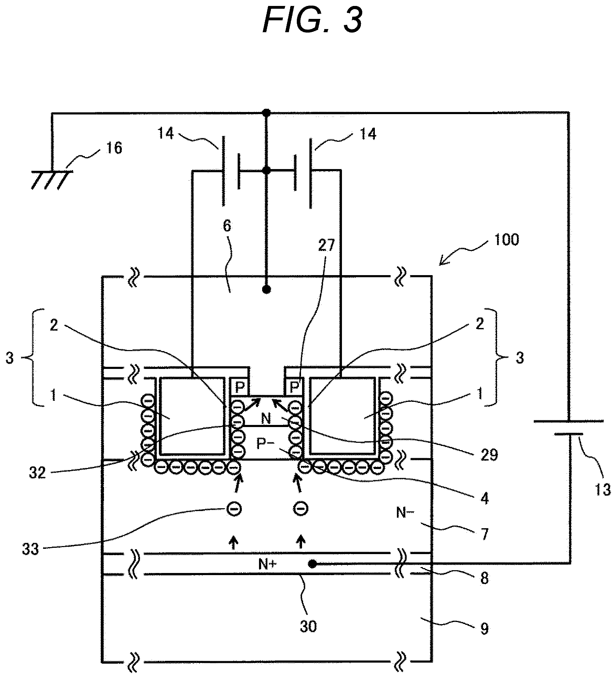

Next, the operation of the semiconductor device 100 according to the present embodiment will be described with reference to FIGS. 2 and 3. FIG. 2 schematically indicates the distribution of hole carriers when a negative voltage 31 is applied to the gate electrode 1, and a forward voltage 13 is applied to conduct between the cathode electrode 9 and the anode electrode 6. By setting the gate electrode 1 to a negative potential with respect to the anode electrode 6, a hole accumulation layer 73 is formed at the interface of the P- type anode layer 4, the P type anode layer 27, and the gate insulating film 2. Further, at the interface of the gate insulating film 2 of the N type well layer 29, inversion by a gate voltage occurs, and the hole accumulation layer 73 is similarly formed.

Holes are injected from the anode electrode 6 into the P- type anode layer 27 through this hole accumulation layer 73, and also holes 74 are injected into the N- type drift layer 7 via the hole accumulation layer 73. In the N- type drift layer 7, electrons 75 are injected from the N+ type cathode layer 8 induced in the injected holes 74, conductivity modulation occurs, and the forward voltage (VF) decreases. Therefore, by controlling the semiconductor device 100 having this structure and the gate voltage, a conduction loss at the time of diode conduction can be reduced.

On the other hand, the operation when the positive voltage 14 is applied to the gate voltage will be described with reference to FIG. 3. By setting the gate electrode 1 to a positive potential with respect to the anode electrode 6, an electron accumulation layer 32 is formed at an interface between the N type well layer 29 and the gate insulating film 2. At the interface of the gate insulating film 2 of the P- type anode layer 4, inversion is caused by the gate voltage, and the electron accumulation layer 32 is similarly formed. Through the electron accumulation layer 32 and the N type well layer 29, electrons 33 are extracted from the N- type cathode drift layer 7 to the anode electrode 6, conductivity modulation in the N- type cathode drift layer 7 is suppressed, the carrier concentration decreases, and the forward voltage (VF) increases. That is, in this structure, it is possible to shift to an internal state which enables high speed and low loss recovery switching by the gate voltage.

Note that even when the gate voltage is not the positive voltage 14, and even at zero bias, the concentration of electrons generated at the interface of the N type well layer 29 and the gate insulating film 2 and at the interface of the gate insulating film 2 of the P-type anode layer 4 can be increased as compared with the case where a negative voltage is applied. As a result, electrons are extracted from the N- type cathode drift layer 7 to suppress conductivity modulation in the N- type cathode drift layer 7, and the carrier concentration can be reduced.

In the present invention, constantly connected diode portions disclosed in PTLS 1 and 2 and including only a diode portion having a gate are not connected in parallel. The carrier concentration of the N- type cathode drift layer 7 is completely controlled by a gate voltage, and the controllability by a gate voltage of the carrier concentration is higher than the conventional controllability.

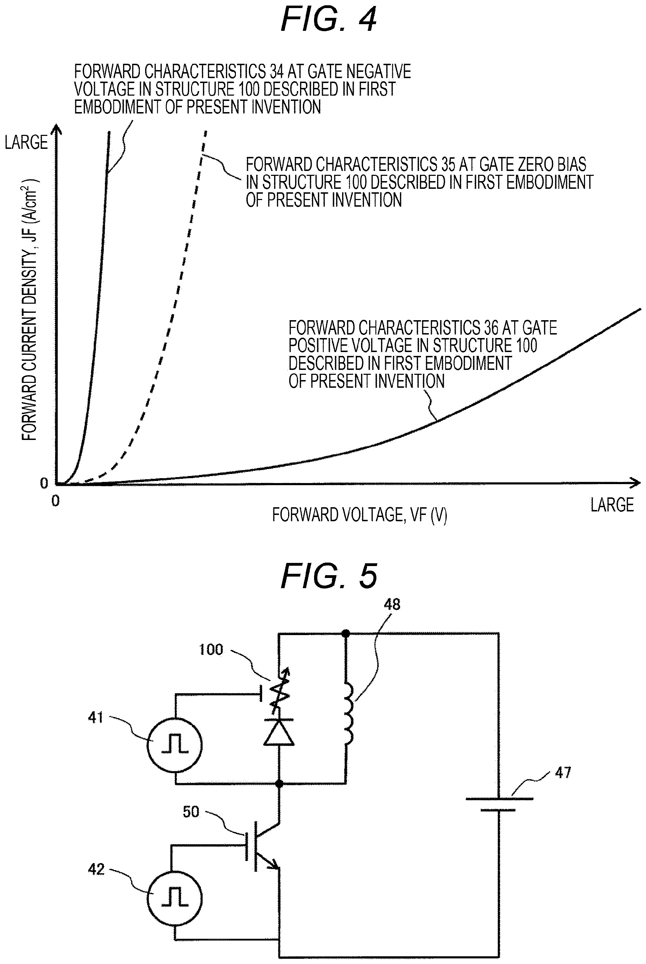

FIG. 4 illustrates the forward characteristics of the diode to which the present invention is applied. When a negative voltage is applied to the gate voltage, holes are injected at a high concentration from anode, and the conductivity modulation is accelerated inside a drift layer, such that a high current density can flow with a low forward voltage. When a zero bias is applied to the gate voltage, injection of holes from the anode is suppressed, electrons are absorbed into the anode, and conductivity modulation inside the drift layer is suppressed, such that the forward voltage increases in the case where a negative voltage is applied to the gate voltage. In addition, when a positive voltage is applied to the gate voltage, the change is conspicuously observed, the carrier concentration inside the drift layer further decreases, and the forward voltage further increases.

In this way, it is possible to derive low conduction loss characteristics by the gate voltage and to shift to an internal state that produces recovery switching characteristics with high speed and low loss. Further, in the present invention, as illustrated in FIGS. 1 and 3, the anode electrode 6 has a downwardly convex shape and has a structure in contact with the N type well layer 29, a current path of electrons from the gate oxide film 2 to the anode electrode 6 of the N type well layer 29 is short, and a zero bias or positive voltage is applied to the gate voltage to suppress a voltage drop in the N type well layer 29 when electron current flows.

Therefore, a parasitic PNP bipolar transistor including the P type anode layer 27, the N type well layer 29, and the P- type anode layer 4 is difficult to operate, and latch-up tolerance is high (it becomes difficult to latch up). As a result, even when a high current density flows in a diode, hole injection can be suppressed without latching up, and therefore a drift region with high VF and a low carrier concentration can be formed.

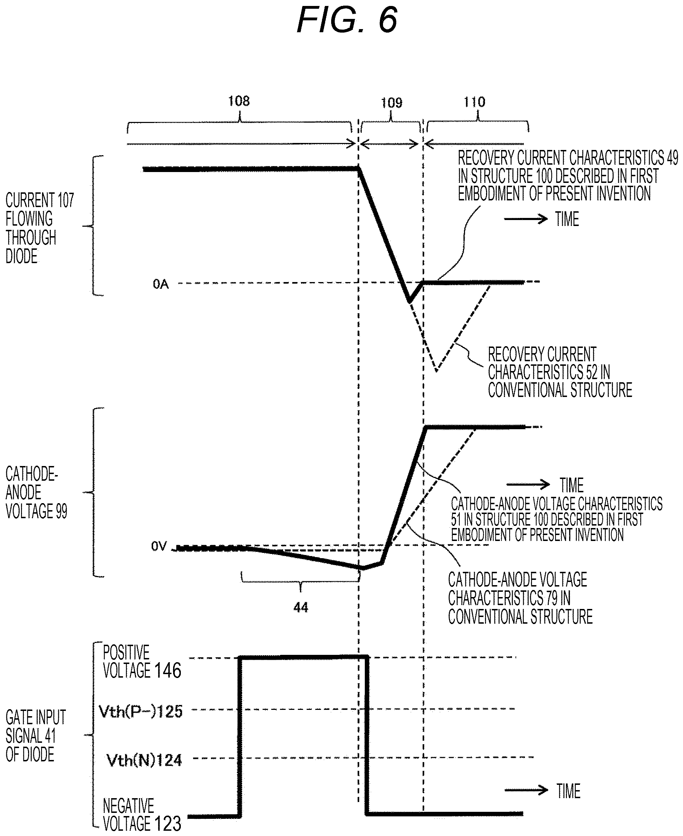

Next, with reference to FIGS. 5 and 6, effects of the present invention at the time of conduction and at the time of recovery switching will be described. FIG. 5 is a circuit diagram of an evaluation circuit for evaluating the recovery characteristics of a diode assuming the operation of a power converter that generates an AC output from a DC power supply. A diode 100 to which the present invention is applied and an arm IGBT 50 are connected in series with respect to a DC power supply 47, and an inductive load 48 is connected in parallel to the diode 100. In an evaluation circuit, in response to an input signal 42 to a gate of the IGBT 50, an AC output voltage is generated at both ends of the inductive load 48.

FIG. 6 illustrates a current 107 flowing through the diode 100 to which the present invention is applied, a cathode-anode voltage 99, and an input signal 41 of the diode 100. In a period 108, the arm IGBT 50 is in an OFF state, a return current flows through the diode 100 and the inductive load 48, and the diode 100 is in a conducting state. In a period 109, the input signal 42 of the gate of the arm IGBT 50 is turned on, and at the same time that the return current with the inductive load 48 flowing through the diode 100 rapidly disappears, the voltage between the cathode and the anode of the diode 100 rises to the power supply voltage 47, and the diode rapidly transitions from a conduction state to a reverse direction state.

Here, in the diode 100, when holes which are minority carriers contributing to conductivity modulation return to an anode electrode, a large current called a recovery current is generated, and a switching loss occurs due to the applied high voltage. This transient state is called a "recovery state". In a period 110, the arm IGBT 50 is in an on-state, and a high voltage by the DC power supply 47 is applied to the diode 100. Hereinafter, effects of the present invention in the period 108 in which the diode 100 is in a conductive state and the period 109 in a recovery state are described.

In the period 108 during which the diode 100 is in a conducting state, a negative voltage 123 is applied to the input signal 41 of the gate of the diode 100 to which the present invention is applied, holes are injected to promote conductivity modulation, and low conduction loss characteristics due to a low forward voltage (VF) can be generated. Here, it is appropriate that the negative voltage 123 input to the diode 100 is lower than a threshold voltage Vth(N) 124 at which the hole accumulation layer 73 is formed to the N type well layer 29 due to inversion by the gate voltage as indicated in FIG. 2.

Next, immediately before the transition to the period 109 in which the diode 100 is in the recovery state, that is, immediately before the arm IGBT 50 is turned on, by inputting a pulse signal of the positive voltage 146 from a negative voltage state, the input signal 41 of the gate of the diode 100 to which the present invention is applied can be shifted to the recovery state in a state 44 in which the conductivity modulation is suppressed, the carrier amount is temporarily low, and the forward voltage (VF) is high. Here, the input time of the pulse signal of the positive voltage 146 is a time during which holes in the drift region excessive by extracting electrons by a gate voltage disappears to stabilize to a low carrier concentration, that is, 1 µsec to several 10 µsec is appropriate.

In addition, the positive voltage 146 input to the diode 100 is preferably higher than a threshold voltage Vth (P-) 125 at which the electron accumulation layer 32 is formed due to inversion by the gate voltage is applied to the P- type anode layer 4 as illustrated in FIG. 3.

Now that the voltage applied may not be the positive voltage 146 according to the value of Vth (P-) 125 but may be effective even at a zero bias. By applying the structure of the present invention and this control, it is possible to significantly reduce the recovery current 49 transiently flowing through the diode 100 with respect to the recovery current 52 generated in conventional diodes without a switching function or diodes according to PTLS 1 and 2. In this period, since the recovery current and a cathode-anode voltage 51 increase, the power consumption called a recovery loss occurs, lowering the recovery current indicates that the recovery loss is reduced.

From the above, by applying the present invention, it is possible to realize a low loss diode with both a low conduction loss and a low recovery loss.

### Second Embodiment

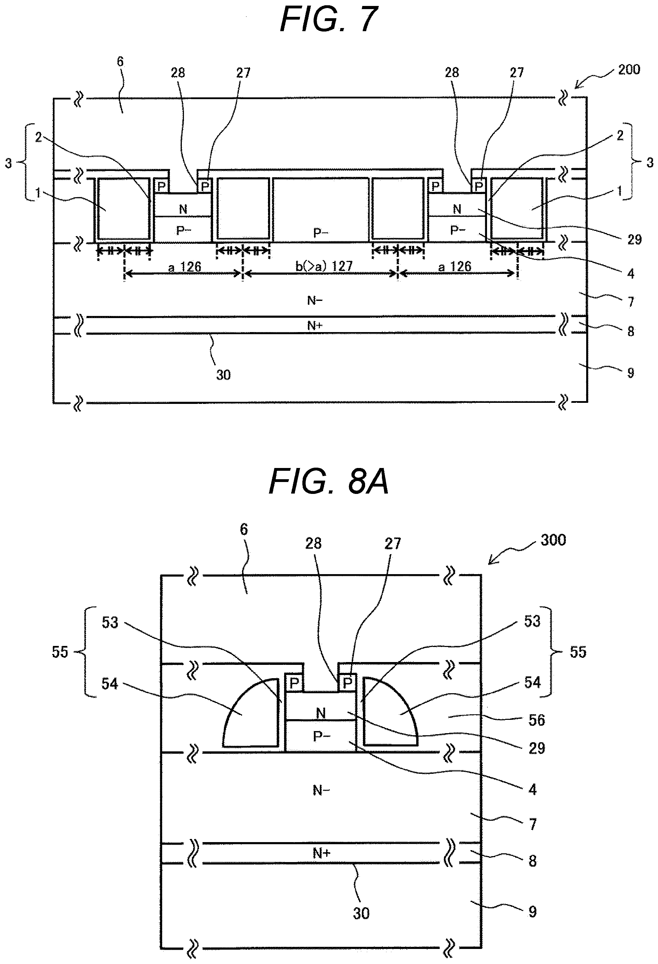

An insulated gate type (gate control type) semiconductor device 200 according to a second embodiment of the present invention will be described with reference to FIG. 7. FIG. 7 is a cross-sectional view of an insulated gate type vertical semiconductor device of the present embodiment, and a plurality of insulated gates 3 of a trench gate type (four insulated gates 3 are illustrated here) are disposed.

This embodiment is a trench gate control type diode and includes an N- type cathode drift layer 7, a P- type anode layer 4 vertically adjacent to the N- type cathode drift layer 7, an N+ type cathode layer 8 vertically adjacent to the N- type cathode drift layer 7 on the side opposite to the P- type anode layer 4. Furthermore, an N type well layer 29 is adjacent on an upper portion of the P- type anode layer 4, and a P type anode layer 27 is provided thereon. The P- type anode layer 4, the N type well layer 29, and the P type anode layer 27 are in contact with the trench gate type insulated gate 3 having a gate electrode 1 via a gate insulating film (gate oxidation) 2.

That is, an anode region includes the P- type anode layer 4, the N type well layer 29, and the P type anode layer 27 in order from a lower layer to an upper layer.

An anode electrode 6 has a downwardly convex trench shape and is in contact with the P type anode layer 27 and the N type well layer 29, and the anode electrode 6 is electrically separated from the P- type anode layer 4 via the N type well layer 29. Furthermore, the anode electrode 6 is electrically connected to the P type anode layer 27 by a Schottky or an ohmic contact (barrier) 28, and the cathode electrode 9 is electrically connected to the N+ type cathode layer 8 by an ohmic contact 30. Note that the semiconductor layer used here is formed of silicon (Si) or silicon carbide (SiC), and a gate insulating film 2 is formed of silicon dioxide (SiO₂).

That is, the anode electrode 6 has a convex shape from an upper layer to a lower layer, and a position in contact with the P type anode layer 27 is formed to be higher than a position in contact with the N type well layer 29. Both the N type well layer 29 and the P type anode layer 27 are electrically connected to the anode electrode 6 and electrically separated from a semiconductor substrate.

In the present embodiment, an interval a126 between two gate electrodes 3 sandwiching the P- type anode layer 4, the N type well layer 29, and the P type anode layer 27 is narrower than an interval b127 between the adjacent other gate electrodes, that is, b > a. Here, a126 and b127 are defined as a distance between the centers of the gate electrodes 1 on the gate oxide film 2 in contact with the N- type cathode drift layer 7.

According to the present embodiment, it is possible to prevent electron carriers injected from the cathode electrode 9 into the cathode drift layer 7 from escaping to the anode electrode 6 when the diode 200 is in a conductive state, and the conductivity modulation effect inside the cathode drift layer 7 can be further promoted in comparison with the structure in which a = b or a > b. Therefore, in the conduction state in which the forward current flows through the diode 200, the effect of reducing the forward voltage by applying a negative voltage to the gate can be further enhanced by applying this structure. Therefore, it is possible to provide a diode having further low conduction loss performance.

### Third Embodiment

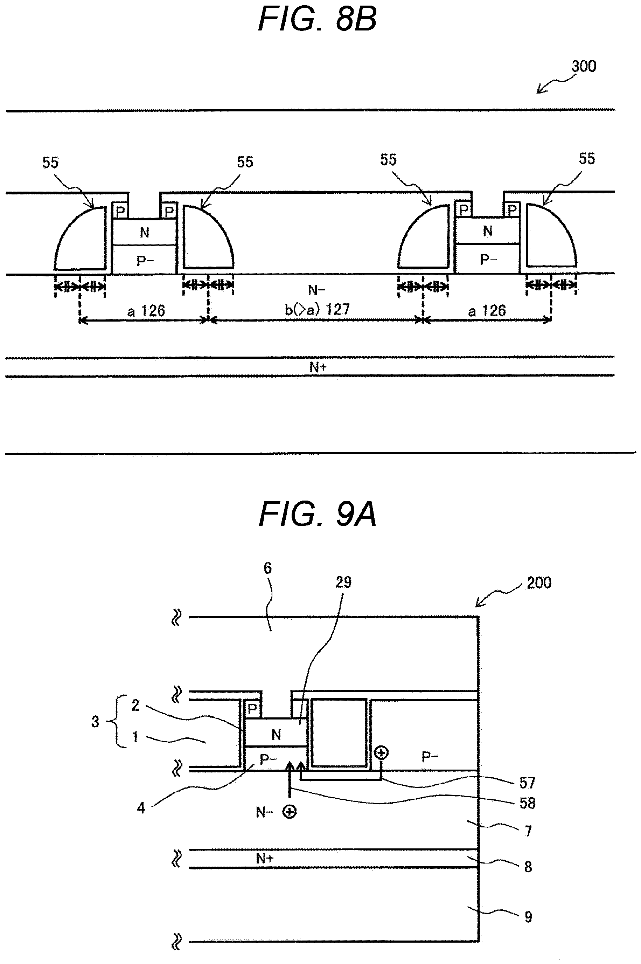

An insulated gate type (gate control type) semiconductor device 300 according to a third embodiment of the present invention will be described with reference to FIGS. 8A and 8B. FIGS. 8A and 8B are cross-sectional views of an insulated gate type vertical semiconductor device according to the present embodiment, and particularly relates to a side gate shape in which a gate electrode is embedded only in a side wall with respect to a trench. FIG. 8A partially illustrates the vicinity of two side gate type insulated gates 55. FIG. 8B illustrates a state in which a plurality of side gate type insulated gates 55 (here, four side gate type insulated gates 55) are disposed.

The present embodiment applies a side gate control type diode and includes an N- type cathode drift layer 7, a P- type anode layer 4 vertically adjacent to the N- type cathode drift layer 7, an N+ cathode layer 8 vertically adjacent to the N- type cathode drift layer 7 on the side opposite to the P- type anode layer 4. Furthermore, this embodiment is provided with the side gate type insulated gate 55 having a so-called sidewall shape, in which in the side gate type gate electrode 54 provided on a surface of the P- type anode layer 4 via the side gate type gate insulating film (gate oxide film) 53, an insulating film 56 is disposed on the side facing the P- anode layer 4, and the P- anode layer 4 exists only on one side with respect to the gate electrode 54. Furthermore, an N type well layer 29 is adjacent on an upper portion of the P- type anode layer 4, and a P type anode layer 27 is provided thereon. The P- type anode layer 4, the N type well layer 29, and the P type anode layer 27 are in contact with the side gate type insulated gate 55 having the gate electrode 54 via the gate insulating film 53.

An anode electrode 6 has a downwardly convex trench shape and is in contact with the P type anode layer 27 and the N type well layer 29, and the anode electrode 6 is electrically separated from the P- type anode layer 4 via the N type well layer 29. Furthermore, the anode electrode 6 is electrically connected to the P type anode layer 27 by a Schottky or an ohmic contact (barrier) 28, and the cathode electrode 9 is electrically connected to the N+ type cathode layer 8 by an ohmic contact 30. Note that the semiconductor layer used here is formed of silicon (Si) or silicon carbide (SiC), and the gate insulating film 2 is formed of silicon dioxide (SiO₂).

In other words, the gate electrode of the present embodiment is formed as a side gate type gate electrode having a sidewall shape in which its width increases from an upper layer side to a lower layer side. Further, as illustrated in FIG. 8B, the anode region of the present embodiment is provided so as to be sandwiched between two side gate type insulated gates 55. In addition, a plurality of anode regions are provided, a distance between the two side gate type insulated gates 55 sandwiching the anode region is formed so as to be narrower than a distance between the side gate type insulated gate 55 and the side gate type insulated gate adjacent to each of the side gate type insulated gate 55.

In other words, the width of each of a plurality of the trenches is wider than the distance between adjacent trenches, and in one of a plurality of the trenches, one insulated gate 55 is formed to contact different sidewalls of the trench.

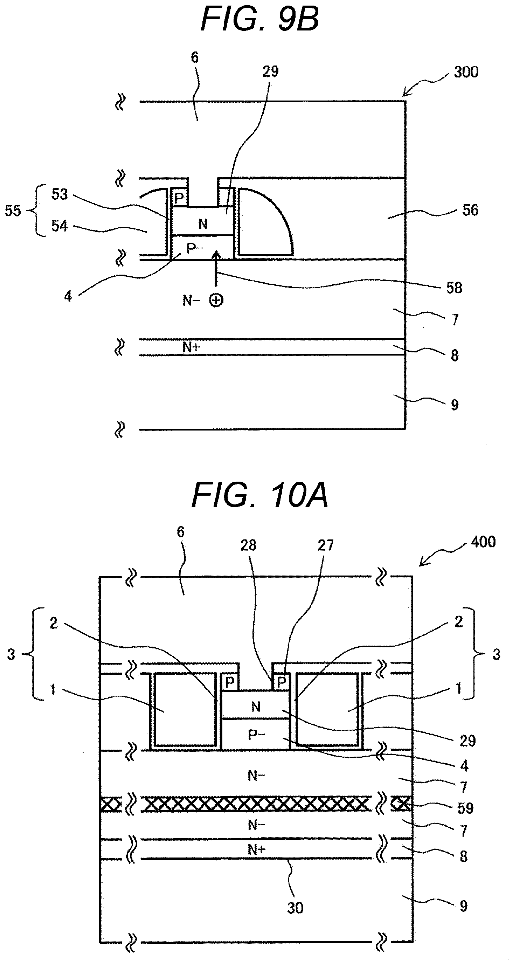

According to the present embodiment, it is possible to further reduce a recovery current as compared with the diode described in the first embodiment. FIGS. 9A and 9B schematically illustrate paths of recovery currents of the diodes according to the second and third embodiments, respectively. In the path of the recovery current of the diode of the second embodiment, a recovery current path 57 extends around the insulated gate 3 from an opposing region and returns to the anode electrode 6. On the other hand, in the diode of the present embodiment, the current path is not disposed as illustrated in FIG. 9B. That is, the recovery current can be reduced, and the effect of reducing a recovery loss can be further improved. Therefore, for the diode of the second embodiment, it is possible to realize a diode having high efficiency with further reduced conduction loss and recovery loss.

### Fourth Embodiment

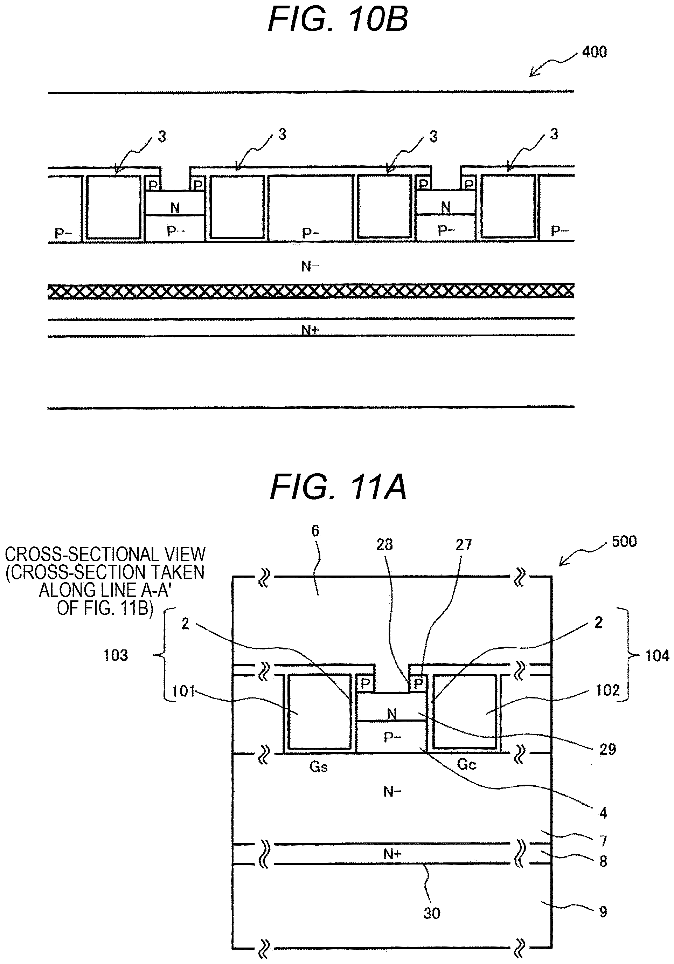

An insulated gate type (gate control type) semiconductor device 400 according to a fourth embodiment of the present invention will be described with reference to FIGS. 10A and 10B. FIGS. 10A and 10B are cross-sectional views of an insulated gate type vertical semiconductor device according to the present embodiment. FIG. 10A partially illustrates the vicinity of two trench gate type insulated gates 3. FIG. 10B illustrates a state in which a plurality of trench gate type insulated gates 3 (here, four insulated gates 3 are illustrated) are disposed.

This embodiment is a trench gate control type diode and includes an N- type cathode drift layer 7, a P- type anode layer 4 vertically adjacent to the N- type cathode drift layer 7, an N+ type cathode layer 8 vertically adjacent to the N- type cathode drift layer 7 on the side opposite to the P- type anode layer 4. Here, an N- type cathode drift layer 59 whose carrier lifetime is reduced is included in the N- type cathode drift layer 7. Furthermore, an N type well layer 29 is adjacent on an upper portion of the P- type anode layer 4, and a P type anode layer 27 is provided thereon. The P- type anode layer 4, the N type well layer 29, and the P type anode layer 27 are in contact with the trench gate type insulated gate 3 having the gate electrode 1 via the gate insulating film (oxidation film) 2.

An anode electrode 6 has a downwardly convex trench shape and is in contact with the P type anode layer 27 and the N type well layer 29, and the anode electrode 6 is electrically separated from the P- type anode layer 4 via the N type well layer 29. Furthermore, the anode electrode 6 is electrically connected to the P type anode layer 27 by a Schottky or an ohmic contact (barrier) 28, and the cathode electrode 9 is electrically connected to the N+ type cathode layer 8 by an ohmic contact 30. Note that the semiconductor layer used here is formed of silicon (Si) or silicon carbide (SiC), and a gate insulating film 2 is formed of silicon dioxide (SiO₂).

According to the present embodiment, the injection controllability of an internal charge by a voltage of a gate can be further improved as compared with the diode described in the first embodiment. Further, it is possible to further reduce a recovery current. This is because, when a positive bias is applied to the gate immediately before recovery, and the electron carriers are extracted, hole carriers remaining in the drift region are more likely to disappear in a lifetime reduction region (reference sign 59 in FIG. 10A) in a drift region. Further, this is also because, due to the lifetime reduction region 59, the concentration of electrons injected from the cathode electrode 30 decreases, and conductivity modulation in the N- type cathode drift layer 59 is suppressed. As a result, it is possible to create a state in which conductivity modulation is further suppressed with the voltage applied to the gate, to further reduce the recovery current when the reverse voltage is applied, and to reduce recovery loss.

### Fifth Embodiment

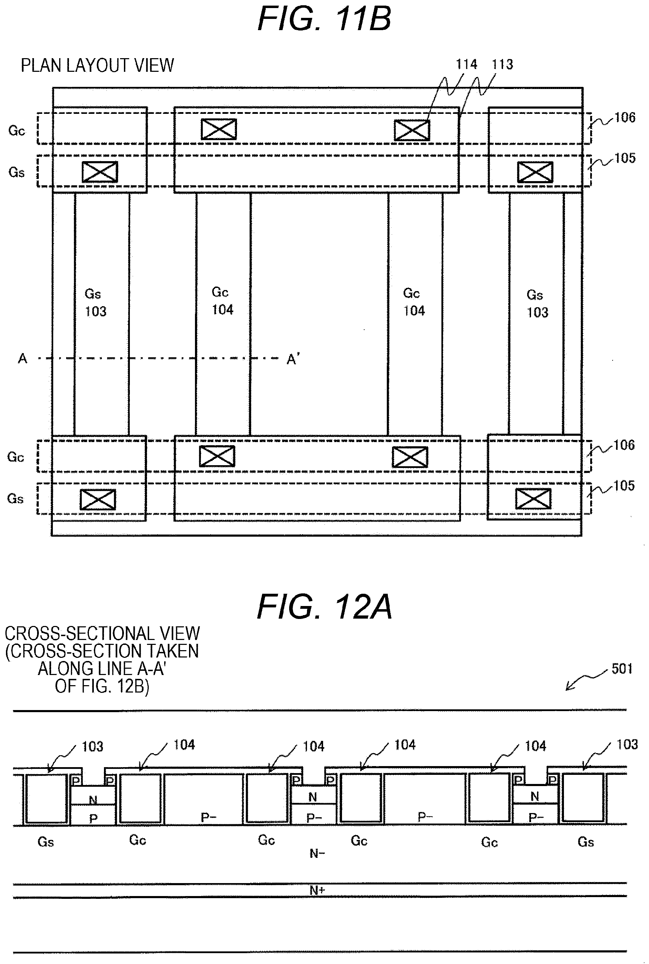

An insulated gate type (gate control type) semiconductor device 500 according to a fifth embodiment of the present invention will be described with reference to FIGS. 11A and 11B. FIG. 11A is a cross-sectional view of an insulated gate type vertical semiconductor device of the present embodiment. Further, FIG. 11B is a plan layout view of the insulated gate type vertical semiconductor device of the present example, and a cross section taken along line A-A' in FIG. 11B is a cross sectional view of FIG. 11A.

This embodiment is a trench gate control type diode and includes an N- type cathode drift layer 7, a P- type anode layer 4 vertically adjacent to the N- type cathode drift layer 7, an N+ type cathode layer 8 vertically adjacent to the N- type cathode drift layer 7 on the side opposite to the P- type anode layer 4. Furthermore, an N type well layer 29 is adjacent on an upper portion of the P- type anode layer 4, and a P type anode layer 27 is provided thereon. The P- type anode layer 4, the N type well layer 29, and the P type anode layer 27 are in contact with the trench gate type insulated gate 3 having a gate electrode 1 via a gate insulating film (gate oxidation) 2.

That is, an anode region includes the P- type anode layer 4, the N type well layer 29, and the P type anode layer 27 in order from a lower layer to an upper layer.

An anode electrode 6 has a downwardly convex trench shape and is in contact with the P type anode layer 27 and the N type well layer 29, and the anode electrode 6 is electrically separated from the P- type anode layer 4 via the N type well layer 29. Furthermore, the anode electrode 6 is electrically connected to the P type anode layer 27 by a Schottky or an ohmic contact (barrier) 28, and the cathode electrode 9 is electrically connected to the N+ type cathode layer 8 by an ohmic contact 30. Note that the semiconductor layer used here is formed of silicon (Si) or silicon carbide (SiC), and a gate insulating film 2 is formed of silicon dioxide (SiO₂).

That is, the anode electrode 6 has a convex shape from an upper layer to a lower layer, and a position in contact with the P type anode layer 27 is formed to be higher than a position in contact with the N type well layer 29. Both the N type well layer 29 and the P type anode layer 27 are electrically connected to the anode electrode 6 and electrically separated from a semiconductor substrate.

According to the present embodiment, two gate electrodes 101 and 102 sandwiching the P- type anode layer 4, the N type well layer 29, and the P type anode layer 27 include two insulated gates 103 and 104 which can be controlled independently of each other. As illustrated in the plan view of FIG. 11B, the two insulated gates 103 and 104 are connected to two gate wirings 105 and 106 which can respectively introduce independent electric signals. Here, the gate wiring and the gate electrode are connected via a contact layer 114. In addition, a plurality of gate electrodes are bundled in a gate wiring through the contact layer 114, and input signals applied to the two gate wirings 105 and 106 are transmitted to the respective gate electrodes.

According to the present embodiment, by applying the same negative voltage to the two gate wirings 105 and 106 when the diode 500 is conducting, a hole accumulation layer having the same concentration is formed at the interface of the insulated gates 103 and 104 of the P- type anode layer 4 and the N type well layer 29, and conductivity modulation in the N- type cathode drift layer 7 is promoted, and the forward voltage can be reduced. On the other hand, immediately before the recovery, one gate wiring 105 maintains a negative voltage, by introducing a positive voltage or zero bias signal to the other gate wiring 106, an electron accumulation layer is formed at the interface between the P- type anode layer 4 and the N type well layer 29 on the insulated gate 104 side, electrons contributing to conductivity modulation can be extracted from the N-type cathode drift layer 7, and carrier concentration can be reduced.

On the other hand, at the interface between the P-type anode layer 4 and the N type well layer 29 on the insulated gate 103 side, the formation of the hole accumulation layer is maintained, and holes are injected into the N- type cathode drift layer 7. With this structure and this control, a temporary increase in the forward voltage immediately before the recovery state, that is, an increase in the conduction loss can be suppressed, and by reducing the carrier concentration in the N- type cathode drift layer 7, low recovery current performance can be derived. By disposing two independent controllable insulated gates indicated with this structure, it is possible to realize a diode having further low loss performance.

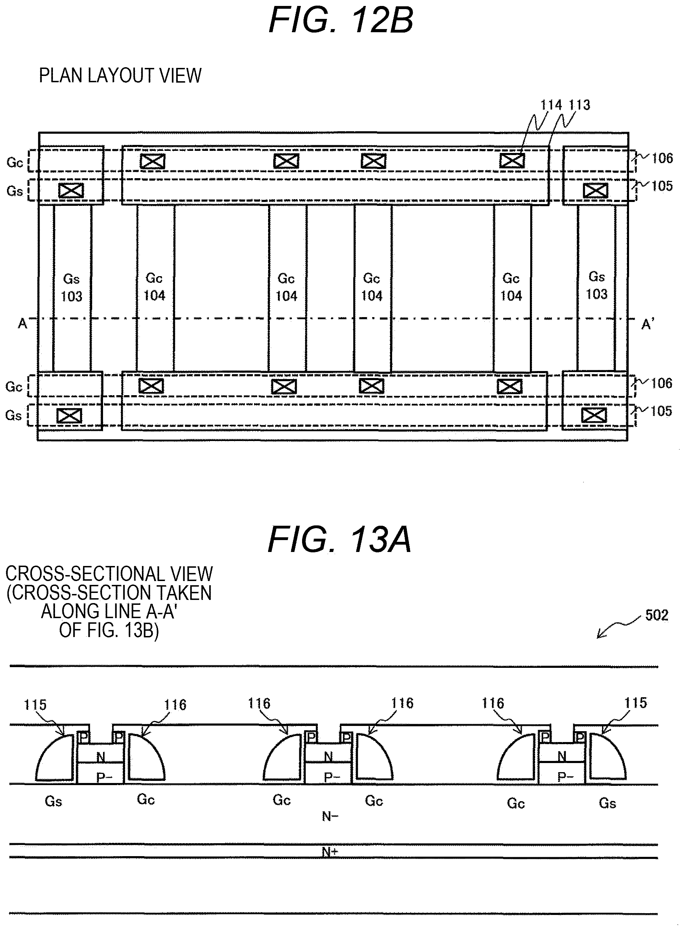

FIGS. 12A and 12B are a cross-sectional view and a plan layout view of an insulated gate type vertical semiconductor device 501 which is a variation of the present embodiment, and a cross section taken along line A-A' in FIG. 12B corresponds to the sectional view of FIG. 12A.

In the present variation, six insulated gates include two insulated gates 103 and 104 which can be controlled independently of each other. As illustrated in the plan view of FIG. 12B, two insulated gates 103 and 104 are connected to two gate wirings 105 and 106 which can respectively introduce independent electric signals. Here, the gate wiring and the gate electrode are connected via a contact layer 114. In addition, a plurality of gate electrodes are bundled in a gate wiring through the contact layer 114, and input signals applied to the two gate wirings 105 and 106 are transmitted to the respective gate electrodes.

In the present variation, a ratio of the number of the insulated gates 103 connected to the gate wiring 105 and the number of the insulated gates 104 connected to the gate wiring 106 is 1 : 2. A negative voltage is applied to two gate wirings 105 and 106 during conduction, and in the case where the control method of applying positive voltage or zero bias signal only to the gate wiring 106 is fixed immediately before the recovery state, by adjusting the number ratio of the insulated gates 103 and 104 connected to the two gate wirings 105 and 106, a carrier concentration immediately before the recovery state can be adjusted.

Both of a conduction loss due to temporary forward voltage rise immediately before recovery state and a recovery loss due to the recovery current depend on the carrier concentration of the N- type cathode drift layer immediately before the recovery state, and the low loss performance that minimizes the sum can be realized by optimally setting the number ratio of the two insulated gates 103 and 104. The number ratio of 1 : 2 indicated in the drawing of the present variation is an example, the optimum ratio depends on the volume of the N- type cathode drift layer, and the present invention is effective in the structure in which the number ratio of the two insulated gates 103 and 104 is increased to 1 or more.

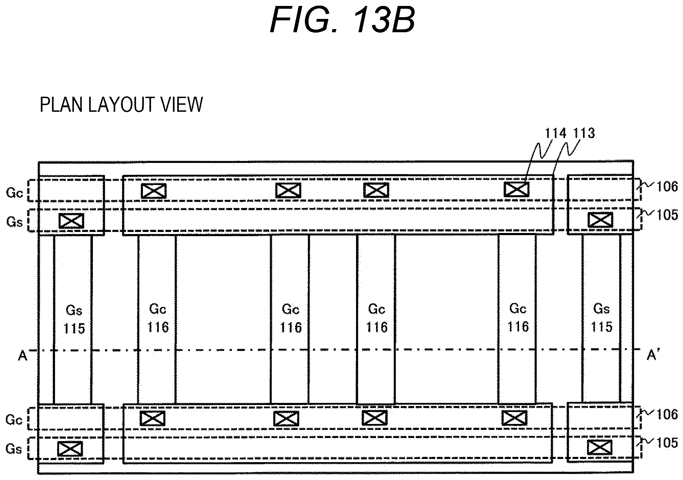

FIGS. 13A and 13B are a sectional view and a plan layout view of an insulated gate type vertical semiconductor device 502 which is a variation of the present embodiment, and more particularly to a side gate shape in which a gate electrode is embedded only in a side wall with respect to a trench. Further, the cross section of line A-A' portion in FIG. 13B corresponds to the cross-sectional view of FIG. 13A.

In the present variation, six side gate-shaped insulated gates include two insulated gates 115 and 116 which can be controlled independently of each other. As illustrated in the plan view of FIG. 13B, two insulated gates 115 and 116 are connected to two gate wirings 105 and 106 which can respectively introduce independent electric signals. Here, the gate wiring and the gate electrode are connected via a contact layer 114. In addition, a plurality of gate electrodes are bundled in a gate wiring through the contact layer 114, and input signals applied to the two gate wirings 105 and 106 are transmitted to the respective gate electrodes.

In the present variation, a ratio of the number of the insulated gates 115 connected to the gate wiring 105 and the number of the insulated gates 116 connected to the gate wiring 106 is 1 : 2. A negative voltage is applied to two gate wirings 105 and 106 during conduction, and in the case where the control method of applying positive voltage or zero bias signal only to the gate wiring 106 is fixed immediately before the recovery state, by adjusting the number ratio of the insulated gates 115 and 116 connected to the two gate wirings 105 and 106, a carrier concentration immediately before the recovery state can be adjusted.

Both of conduction loss due to temporary forward voltage rise immediately before recovery state and recovery loss due to the recovery current depend on the carrier concentration of the N- type cathode drift layer immediately before the recovery state, and the low loss performance that minimizes the sum can be realized by optimally setting the number ratio of the two insulated gates 115 and 116. The number ratio of 1 : 2 indicated in the drawing of the present variation is an example, the optimum ratio depends on the volume of the N- type cathode drift layer, and the present invention is effective in the structure in which the number ratio of the two insulated gates 115 and 116 is increased to 1 or more. In addition, in the side gate type insulated gate indicated in the present variation, as described in the third embodiment, it is possible to reduce the recovery current more than the ordinary trench gate shape and realize a diode having even smaller recovery loss performance.

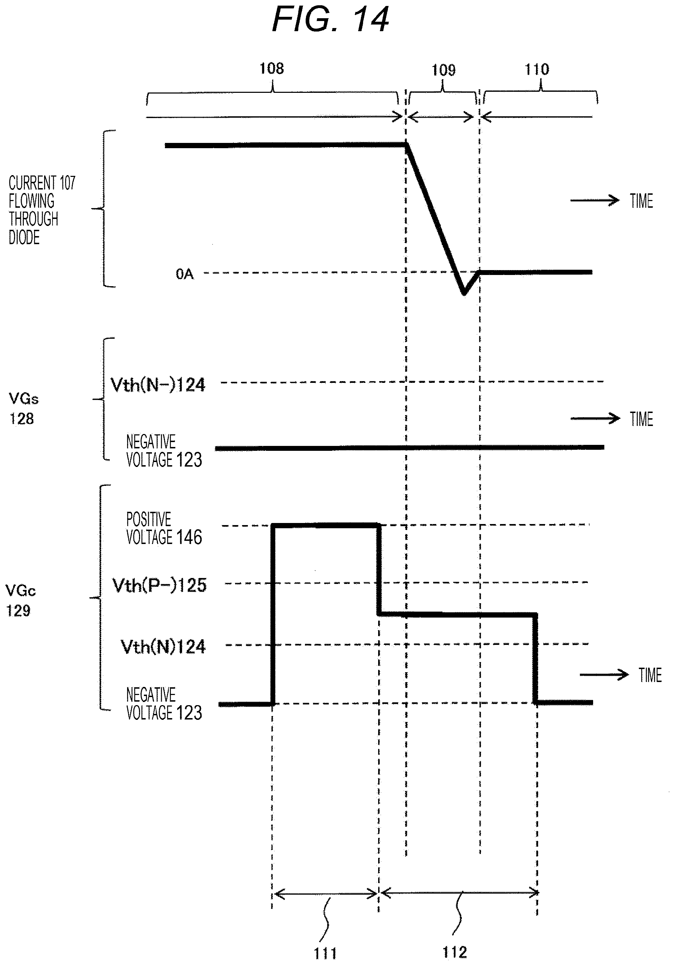

FIGS. 14 to 17 indicate a method of driving an insulated gate type vertical semiconductor device which is a variation of the present embodiment. FIG. 14 indicates the current 107 flowing through the diode to which one example of the present invention is applied, and the input signals VGs 128 and VGc 129 applied to the two gate wirings 105 and 106. By constantly applying a voltage lower than a threshold voltage Vth (N) 124 for forming an inversion layer to the N type well layer 29, the VGs 128 forms a hole accumulation layer at the interface between the N type well layer 29 and the insulated gate 103 or 115, and in a conduction period 108, the diode injects holes from the hole accumulation layer into the N- type cathode drift layer 7, holes are absorbed through the hole accumulation layer in a recovery period 109.

On the other hand, immediately before the transition to the period 109 to be a recovery state, by applying a voltage higher than a threshold voltage Vth (P-) 125 for forming an inversion layer to the P- type anode layer 29, the VGc 129 forms an electron accumulation layer at an interface between the P- type anode layer 29 and the insulated gate 104 or 116, and by sucking electrons in the N- type cathode drift layer 7 from the anode electrode 6 via the electron accumulation layer, conductivity modulation is suppressed, and carrier concentration is reduced. In a period 109 to be a next recovery state, a concentration of the electron accumulation layer formed at the interface between the P- type anode layer 29 and the insulated gate 104 or 116 is reduced by lowering a voltage to a voltage lower than the threshold voltage Vth (P-) 125. As a result, the inflow of electrons from the anode electrode when a reverse voltage is applied between the cathode and the anode is prevented. By this control, it is possible to derive a performance that achieves both low forward voltage and low recovery loss at the time of conduction.

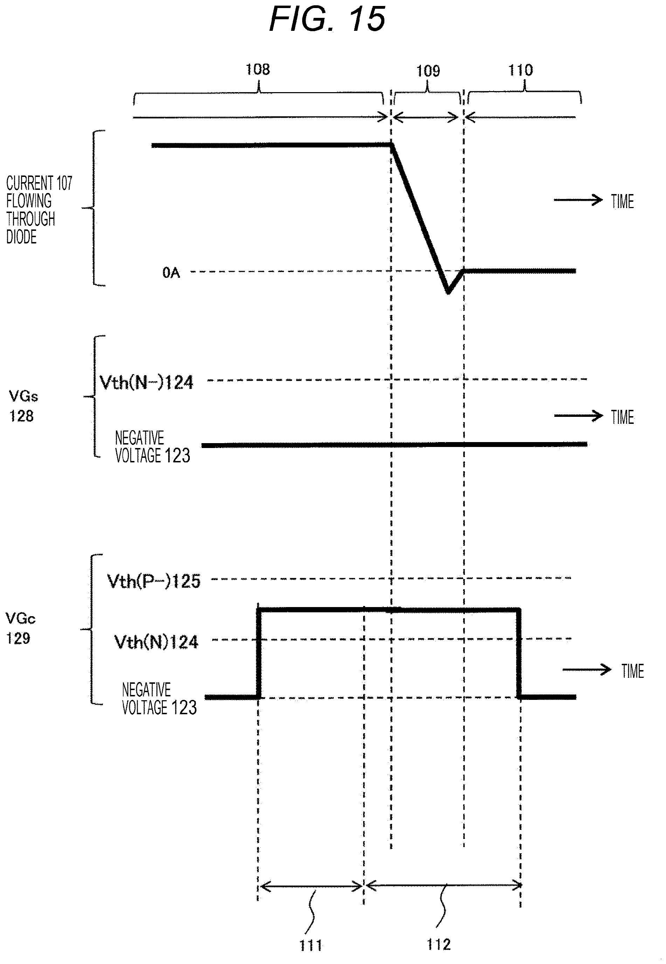

FIG. 15 indicates a control method in which a voltage applied to the VGc 129 is lower than the threshold voltage Vth (P-) 125 immediately before shifting to the period 109 to be a recovery state. Even in this control, since the hole injection from the anode electrode can be suppressed, the carrier concentration in the N- type cathode drift layer 7 can be reduced immediately before recovery, and recovery loss can be reduced.

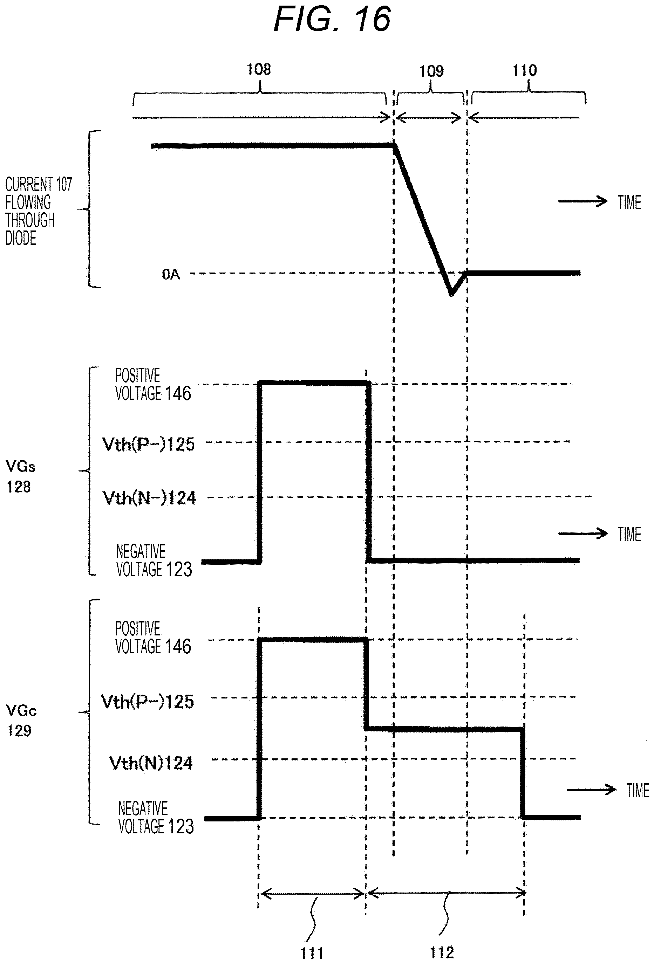

In addition, compared with the control method of FIG. 14, the carrier concentration immediately before recovery is high, and there is an effect of temporarily suppressing the rise of the forward voltage. FIG. 16 indicates a control method of applying a voltage higher than the threshold voltage Vth (P-) 125 to the VGs 128 together with the VGc 129 immediately before shifting to the period 109 to be a recovery state, the carrier concentration immediately before the recovery state can be further reduced, and a further small recovery current performance can be derived.

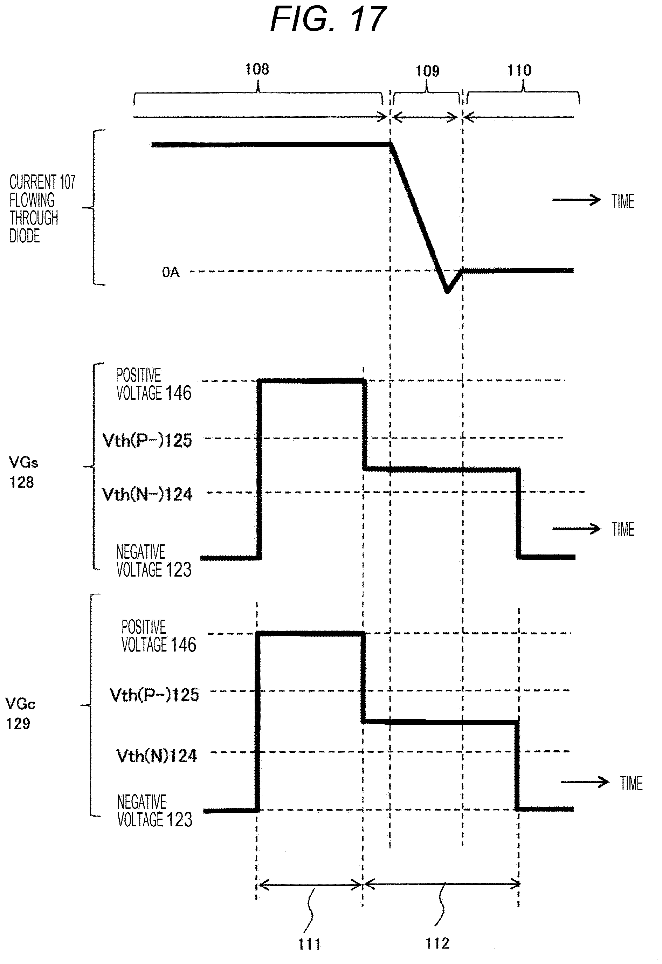

FIG. 17 shows a control method of applying a voltage lower than the threshold voltage Vth (P-) 125 for both VGc 129 and VGs 128 in the recovery period 109. By decreasing the concentration of the electron accumulation layer formed at the interface between the P- type anode layer 29 and the insulated gates 103, 104, 115, and 116, it is possible to prevent the inflow of electrons from the anode electrode when a reverse voltage is applied between the cathode and the anode, and stable low recovery current characteristics can be derived.

In FIG. 14 to FIG. 17, the time 111 required to apply the positive voltage 146 to the VGc 129 or the VGs 128 and lower carrier concentration is appropriately a time during which excessive holes in the drift region by extracting electrons by gate voltage and anode voltage disappear, and low carrier concentration is stabilized, that is, 1 µsec to several 10 µsec. Furthermore, the time 112 for returning to the initial voltage state of a negative voltage after applying the positive voltage 146 to the VGc 129 or the VGs 128 is appropriately a time during which the diode is stabilized by applying a reverse voltage through the recovery period 109, that is, from 0.1 µsec to several µsec.

### Sixth Embodiment

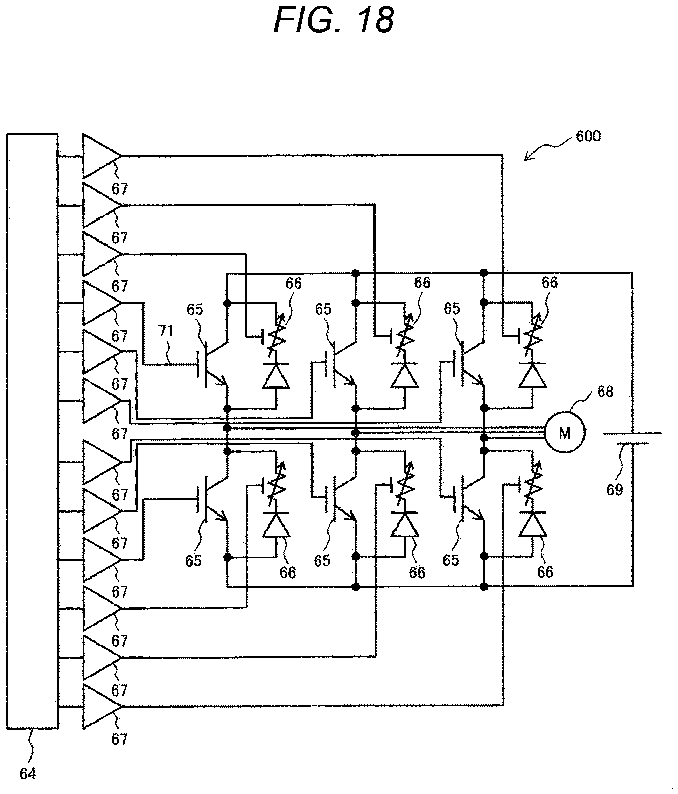

A power conversion device 600 according to a sixth embodiment of the present invention will be described with reference to FIG. 18. The present embodiment includes an arm IGBT 65 in accordance with an IGBT command signal from a control circuit 64, and a drive circuit 67 for driving an insulated gate of a diode 66 Here, the diode 66 is, for example, the gate control type semiconductor devices 100, 200, 300, and 400 indicated in the first, second, third, and fourth embodiments of the present invention.

The drive circuit 67 is mainly a level shift circuit that converts an input from the control circuit 64 into an input signal of the IGBT and the gate of the diode. The driving device (power converter) 500 is an inverter for driving an inductive load 68 mainly including a motor and performs a function to transmit a three-phase AC voltage (electric power) to an inductive load 68 by converting DC voltage (electric power) 69 into three-phase AC voltage (electric power) of U phase, V phase, and W phase.

In addition, the control circuit 64 has a function of generating a timing signal for driving the inductive load 68 and a function of generating a low loss performance of the diode. Therefore, immediately before the IGBT on the lower arm side (upper arm side) turns on, it has a function of generating a signal for applying a voltage to a gate of the upper arm side (lower arm side) diode. Further, the present invention is applied to all of these upper and lower arms diodes as an example. With the low loss performance of the diode according to the present invention indicated in the first, second, third, and fourth embodiments, it is possible to realize a highly efficient inverter with small power loss.

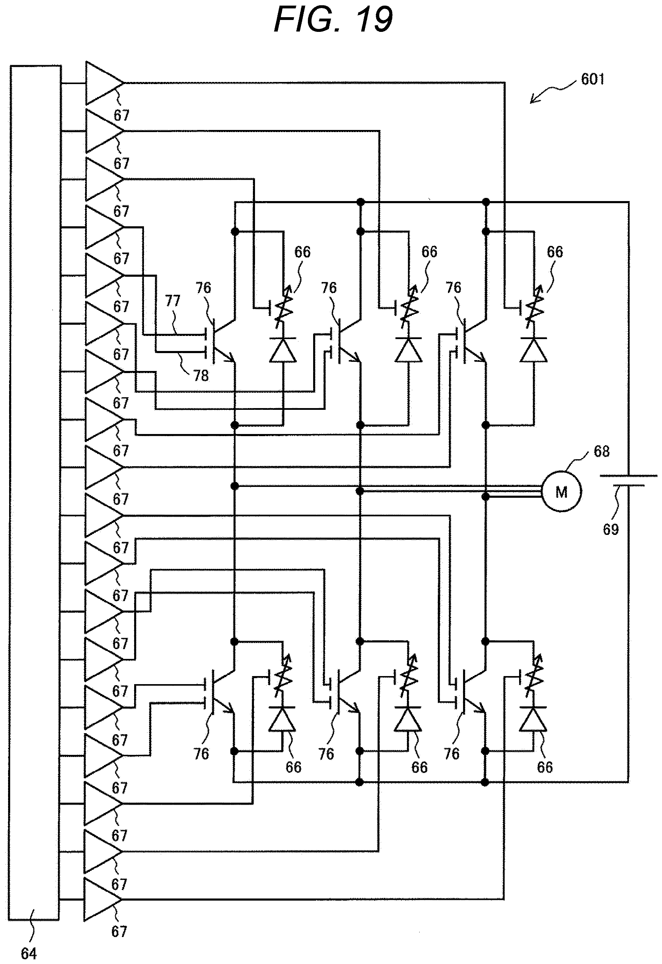

FIG. 19 illustrates a power converter 601 which is a variation of the sixth embodiment of the present invention. The present variation includes a double gate type IGBT 76 having two gate terminals in accordance with the IGBT command signal from the control circuit 64 and a drive circuit 67 for driving the insulated gate of the diode 66. Here, the diode 66 is, for example, the gate control type semiconductor devices 100, 200, 300, and 400 indicated in the first, second, third, and fourth embodiments of the present invention.

The drive circuit 67 is mainly a level shift circuit that converts an input from the control circuit 64 into an input signal of the IGBT and the gate of the diode. In addition, here, the double gate type IGBT 76 is an IGBT in which one gate terminal performs the function of controlling the conductivity modulation inside the IGBT, and the other gate terminal has a role of driving the normal switching operation, and the double gate type IGBT 76 is an IGBT that enables low switching loss performance for normal IGBT. The driving device (power converter) 601 is an inverter for driving an inductive load 68 mainly including a motor and performs a function to transmit a three-phase AC voltage (electric power) to an inductive load 68 by converting DC voltage (electric power) 69 into three-phase AC voltage (electric power) of U phase, V phase, W phase.

In addition, the control circuit 64 has a function of generating a timing signal for driving the inductive load 68 and a function of generating a low loss performance of the diode. Therefore, immediately before the IGBT on the lower arm side (upper arm side) turns on, it has a function of generating a signal for applying a voltage to a gate of the upper arm side (lower arm side) diode. Further, the present invention is applied to all of these upper and lower arms diodes as an example. With the low loss performance of the diode according to the present invention indicated in the first, second, third, and fourth embodiments, it is possible to realize a highly efficient inverter with small power loss.

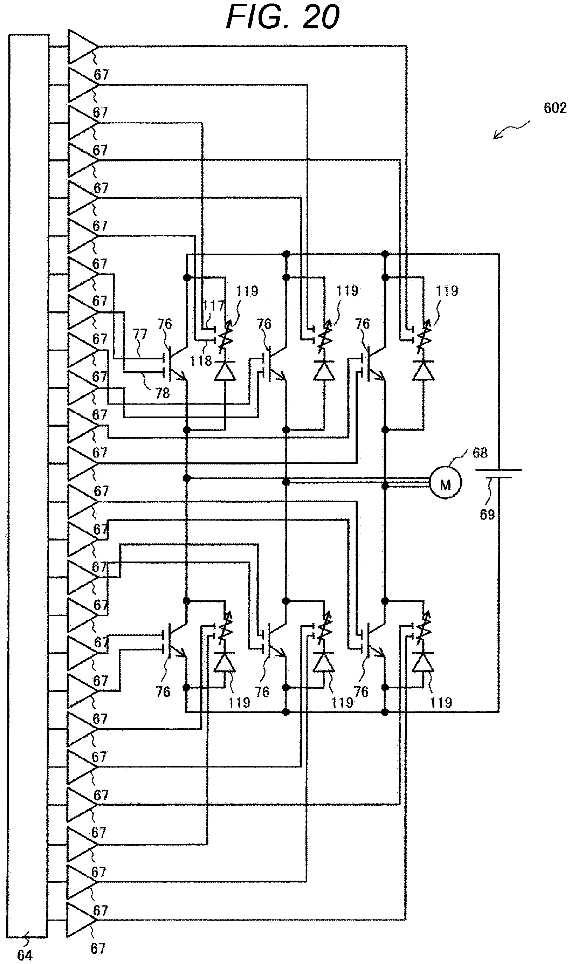

FIG. 20 illustrates a power conversion apparatus 602 which is a variation of the sixth embodiment of the present invention. The present variation includes a double gate type IGBT 76 having two gate terminals in accordance with an IGBT command signal from the control circuit 64 and the drive circuit 67 for driving the two insulated gates 117 and 118 of the diode 119. Here, the diode 119 is, for example, the gate control type semiconductor device 500 indicated in the fifth embodiment of the present invention.

The drive circuit 67 is mainly a level shift circuit that converts an input from the control circuit 64 into an input signal of the IGBT and the gate of the diode. The driving device (power converter) 602 is an inverter for driving an inductive load 68 mainly including a motor and performs a function to transmit a three-phase AC voltage (electric power) to an inductive load 68 by converting DC voltage (electric power) 69 into three-phase AC voltage (electric power) of U phase, V phase, W phase.

In addition, the control circuit 64 has a function of generating a timing signal for driving the inductive load 68 and a function of generating a low loss performance of the diode. Therefore, immediately before the IGBT on the lower arm side (upper arm side) turns on, it has a function of generating a signal for applying a voltage to the two gates 117 and 118 of the upper arm side (lower arm side) diode. Further, the present invention is applied to all of these upper and lower arms diodes as an example. With the low loss performance of the diode according to the present invention indicated in the fifth embodiment, it is possible to realize a highly efficient inverter with a small power loss.

Note that the diode 119 having two insulated gates can contribute to realization of a highly efficient inverter with small power loss even when the diode 119 is combined with the IGBT 65 including one gate illustrated in FIG. 18.

As explained above, according to each embodiment of the present invention, by a diode structure capable of providing a switching function by an insulated gate and a voltage control of the insulated gate, the carrier concentration in the drift region of the diode can be optimized in the conduction state and the recovery state, and it is possible to realize a diode having a performance that achieves both low conduction loss and low recovery loss.

Note that the present invention is applicable to semiconductor devices suitable for those widely used from low power devices such as air conditioners and microwave ovens to large power devices such as automobiles, railroads and ironworks inverters, driving devices for semiconductor circuits, and power converters.

Furthermore, the present invention is not limited to the above-described embodiments and includes various variations.

For example, the above-described embodiments describe the present invention in detail for clarification, and every configuration described above may not be necessarily included. Further, a configuration of the embodiment can be partially replaced with a configuration of the other embodiment. Furthermore, a configuration of the embodiment can be added to a configuration of the other embodiment. Further, a part of a configuration of each embodiment can be added to, deleted from, and replaced from other configurations.

### Reference Signs List

1, 86 gate electrode
2, 85 gate insulating film
3 insulated gate
4, 89 P- type anode layer (region)
6, 80 anode electrode
7, 81 N- type cathode drift layer (region, substrate)
8, 82 N+ type cathode layer (region)
9, 83 cathode electrode
12, 87 P type anode layer (region)
13 forward voltage applied between anode and cathode
14 positive voltage applied between gate and anode
15 electron carrier extracted from drift layer
16 ground potential
17 PNP transistor
18 NPN transistor
19 base resistance of PNP transistor 17
20 electron current caused by electron carriers extracted from drift layer
21 base potential of PNP transistor 17
22 hole current flowing with rise of base potential 21
23 forward characteristics at the time of applying negative gate voltage in structure described in PTL 2.
24 forward characteristics at the time of applying gate positive voltage in structure described in PTL 2.
25 low current density state
26 high current density state
27 P type anode layer
28 Schottky or ohmic contact (barrier)
29, 88 N type well layer
30 Ohmic contact (barrier)
31 negative voltage applied between gate and anode
32 electron accumulation layer
33 electron carrier extracted from drift layer
34 forward characteristics at gate negative voltage in structure 100 according to first embodiment of present invention
35 forward characteristics at gate zero bias in structure 100 according to first embodiment of present invention
36 forward characteristics at gate positive voltage in structure 100 according to first embodiment of present invention
41 input signal of gate of diode to which present invention is applied
42 input signal of gate of arm IGBT
43 diode conduction state
44 state in which conductivity modulation immediately before recovery of diode is suppressed
45 reverse direction state of diode
46 positive voltage pulse input signal
47 DC power supply
48 inductive load
49 recovery current characteristics in structure 100 described in first embodiment of present invention
50 arm IGBT
51 cathode-anode voltage characteristic in structure 100 described in first embodiment of present invention
52 recovery current characteristics in conventional structure
53 side gate type gate insulating film
54 side gate type gate electrode
55 side gate type insulated gate
56 insulating film (oxide film)
57 path of recovery current due to holes returning from region facing insulated gate and returning to anode electrode
58 route of recovery current by holes
59 N- type cathode drift layer with reduced carrier lifetime
60 mask used for trench processing of anode electrode
61 impurity ion implantation for forming N type anode layer
62 Impurity ion implantation for forming P type anode layer
63 irradiation of lifetime killer
64 control circuit
65 IGBT
66 diodes to which the present invention is applied
67 drive circuit for driving insulated gate of IGBT and diode
68 inductive load
69 DC voltage (power) source
70 IGBT
71 insulated gate (terminal) of IGBT 70
72 diode connected in reverse parallel with IGBT 70
73 hole accumulation layer
74 hole carrier injected into N- drift layer and contributing to conductivity modulation
75 electron carrier injected into N- drift layer and contributing to conductivity modulation
76 double gate type IGBT
77 insulated gate 1 of double gate type IGBT 76
78 insulated gate 2 of double gate type IGBT 76
79 cathode-anode voltage characteristics in conventional structure
84 trench separation
90 P type anode auxiliary layer
99 cathode-anode voltage of diode 100 to which present invention is applied
100 insulated gate type (gate control type) semiconductor device of first embodiment of present invention
101 first insulated gate electrode
102 second insulated gate electrode
103 first insulated gate Gs
104 second insulated gate Gc
105 first gate wiring Gs
106 second gate wiring Gc
107 current flowing through diode 100 to which present invention is applied
108 period during which diode is in conduction state
109 period during which diode is in recovery state
110 period during which diode is in reverse bias state
111 time required for applying positive voltage 146 and lowering carrier concentration
112 holding time to restore to initial voltage state of negative voltage after applying positive voltage 146
113 aggregate pattern of gate electrode
114 contact layer of gate electrode and gate wiring
115 first side gate type insulated gate Gs
116 second side gate type insulated gate Gc
121 diode portion that is always connected
122 diode portion with conduction/non-conduction control function by MOSFET switch
123 negative voltage
124 threshold voltage Vth (N) causing inversion layer in N type well layer 29
125 threshold voltage Vth (P-) for generating inversion layer in P- type anode layer 4
126 distance a between two gate electrodes 3 sandwiching P- type anode layer 4, N type well layer 29, and P type anode layer 27
127 distance b between adjacent other gate electrodes
128 voltage VGs applied to first gate wiring Gs
129 voltage VGc applied to second gate wiring Gc
146 positive voltage
200 insulated gate type (gate control type) semiconductor device according to second embodiment of present invention
300 insulated gate type (gate control type) semiconductor device according to third embodiment of present invention
400 insulated gate type (gate control type) semiconductor device according to fourth embodiment of present invention
500 insulated gate type (gate control type) semiconductor device according to fifth embodiment of present invention
501 insulated gate type (gate control type) semiconductor device according to first variation of fifth embodiment of present invention
502 insulated gate type (gate control type) semiconductor device according to second variation of fifth embodiment of present invention
600 power converter according to sixth embodiment of present invention
601 power converter of first variation of sixth embodiment of present invention
602 power converter according to second variation of sixth embodiment of present invention

## Claims

1. A semiconductor device, comprising:
a first conductivity type semiconductor substrate;
a first conductivity type cathode region provided on a side of a first surface of the semiconductor substrate;
an anode region provided on a side of a second surface opposite to the first surface side of the semiconductor substrate;
an anode electrode adjacent to the second surface side of the anode region; and
a gate electrode adjacent to the anode region via a gate insulating film,
wherein the gate electrode is surrounded by the gate insulating film in a trench that extends from the second surface to the cathode region through the anode region,
the anode region includes, in order from the first surface side to the second surface side, a second conductivity type first anode region, a first conductivity type well region, and a second conductivity type second anode region,
the first anode region is separated from the second anode region and the anode electrode by the well region,
both the well region and the second anode region are connected to the anode electrode and separated from the semiconductor substrate,
the first anode region, the well region, and the second anode region are all adjacent to the gate electrode via the gate insulating film,
when a negative bias is applied to the gate electrode with respect to the anode electrode, an inversion layer is formed in a portion of the well region in contact with the gate insulating film, and when a positive bias is applied to the anode electrode with respect to a cathode electrode, holes are injected from an inversion layer formed in the well region into a drift layer.

2. The semiconductor device according to claim 1,
wherein the first anode region, the well region, and the second anode region are provided so as to be sandwiched between two gate electrodes,
a plurality of the first anode regions, the well regions, and the second anode regions are provided on the second surface side, and
a distance between the two gate electrodes sandwiching the first anode region, the well region, and the second anode region is narrower than a distance between the gate electrode and another gate electrode adjacent to each gate electrode.

3. The semiconductor device according to claim 2,
wherein the gate electrode is in contact with different sidewalls of one trench, and
the gate electrode is a side gate type gate electrode having a sidewall shape in which the width increases from the second surface side to the first surface side.

4. The semiconductor device according to any one of claims 1 to 3,
wherein a lifetime control region for performing lifetime control of carriers is provided in the cathode region.

5. The semiconductor device according to any one of claims 2 to 4,
wherein a negative bias for forming an inversion layer to the well region is applied to the gate electrode in a conduction period during which a forward current flows to the semiconductor device,
a positive bias or a zero bias for forming an inversion layer in the first anode region is applied to the gate electrode before a period in which the semiconductor device transitions from a conduction state to a non-conduction state,
a voltage lower than a threshold voltage for forming an inversion layer in the first anode region is applied to the gate electrode during the period in which the semiconductor device transitions from the conduction state to the non-conduction state, and
the negative bias for forming the inversion layer in the well region is applied to the gate electrode in the non-conduction period of the semiconductor device.

6. The semiconductor device according to any one of claims 2 to 4,
wherein a part of the gate electrode is connected to a first gate terminal, a remaining part of the gate electrode is connected to a second gate terminal, and the partial gate electrode and the remaining gate electrode can be controlled independently of each other via the first and second gate terminals.

7. The semiconductor device according to claim 6,
wherein, during a conduction period in which a forward current flows in the semiconductor device, a part of the gate electrode connected to the first gate terminal and the remaining gate electrode connected to the second gate terminal are applied with a negative bias for forming an inversion layer in the well region,
before a period in which the semiconductor device transitions from a conduction state to a non-conduction state, a part of the gate electrode connected to the first gate terminal is applied with a bias lower than a threshold voltage for forming an inversion layer in the first anode region and higher than a threshold voltage for forming an inversion layer in the well region is applied.

8. The semiconductor device according to claim 7,
wherein before the period in which the semiconductor device transitions from the conduction state to the non-conduction state, a bias lower than a threshold voltage for forming an inversion layer in the first anode region is applied to the remaining gate electrode connected to the second gate terminal.

9. The semiconductor device according to claim 8,
wherein in a non-conduction period of the semiconductor device, a part of the gate electrode connected to the first gate terminal and the remaining gate electrode connected to the second gate terminal are applied with the negative bias for forming the inversion layer in the well region.

10. The semiconductor device according to claim 9,
wherein before the period in which the semiconductor device transitions from the conduction state to the non-conduction state, a part of the gate electrode connected to the first gate terminal or a part of the gate electrode connected to the first gate terminal and the remaining gate electrode connected to the second gate terminal are applied with a positive bias or zero bias for forming an inversion layer in the first anode region.

11. The semiconductor device according to any one of claims 1 to 10,
wherein a switching element including an insulated gate bipolar transistor capable of applying a driving signal is connected to the semiconductor device, and a power conversion function is provided.

12. The semiconductor device according to any one of claims 1 to 10,
wherein a switching element including an insulated gate bipolar transistor having a first gate terminal and a second gate terminal and applying driving signals different from each other to the first gate terminal and the second gate terminal is connected to the semiconductor device, and the power conversion function is provided.
